# EUROPÄISCHE PATENTSCHRIFT

(11) **EP 0 418 848 B1**
(45) Veröffentlichungstag und Bekanntmachung des Hinweises auf die Patenterteilung: **25.01.1995**
(21) Anmeldenummer: 90117999.4
(22) Anmeldetag: 19.09.1990
(51) Int. Cl.: G01R 33/035

(54) **Sensor zum Messen von magnetischem Fluss**
Sensor for the measurement of magnetic flux
Capteur pour la mesure de flux magnétique

(30) Priorität: 21.09.1989 DE 3931441; 02.04.1990 US 503618
(43) Veröffentlichungstag der Anmeldung: 27.03.1991
(73) Patentinhaber: FORSCHUNGSZENTRUM JÜLICH GMBH, 52425 Jülich (DE)
(72) Erfinder: Mück, Hans-Michael, Dr., D-6332 Ehringhausen (DE); Heiden, Christoph, Prof.-Dr., D-5170 Jülich (DE)

(56) Entgegenhaltungen:
- US-A- 4 227 096
- IEEE TRANSACTIONS ON MAGNETICS. Bd. MAG19, Nr. 3, Mai 1983, NEW YORK US Seiten 591 - 593; J.F. GARNIER ET AL.: 'Shunted DC SQUIDs with Nb-NbOx-Pb Technology'
- IEEE TRANSACTIONS ON MAGNETICS. Bd. MAG17, Nr. 1, Januar 1981,NEW YORK US Seiten 400 - 403; J.M. JAYCOX ET AL.: 'Planar Coupling Scheme forUltra Low-noise DC SQUIDs.'
- PATENT ABSTRACTS OF JAPAN, vol. 014, no. 413 (E-0974)6.September 1990, & JP-A-02 156 687

## Beschreibung

Die Erfindung bezieht sich auf einen Sensor zum Messen von magnetischem Fluß, bestehend aus einem supraleitenden Ring mit inkorporiertem Josephsonelement, der an einen elektrischen Schwingkreis angekoppelt ist.

Bei derartigen Sensoren ist der supraleitende Ring mit inkorporiertem Josephsonelement in Dünnfilmtechnik hergestellt, wobei Ring und Josephsonelement durch Aufdampfen oder Kathodenzerstäubung als dünne Schicht auf einem Substrat, welches möglichst niedrige dielektrische Verluste aufweist, aufgebracht sind.

Zum Betrieb dieser bekannten Sensoren werden sie im allgemeinen an einen elektrischen Parallelschwingkreis, im folgenden Tankkreis genannt, der ebenfalls supraleitend sein kann, mit Resonanzfrequenz f angekoppelt, in welchen wiederum ein Hochfrequenzstrom mit gleicher Frequenz f eingeprägt wird. Der supraleitende Ring bedämpft den Tankkreis, wobei die Größe der Dämpfung vom magnetischen Fluß durch den supraleitenden Ring abhängig ist. Dadurch ändert sich der Spannungsabfall über dem Tankkreis, was zum Auslesen des Sensors verwendet wird.

Es ist ferner bekannt, daß das Eigenrauschen dieser Sensoren und damit deren maximale Empfindlichkeit gesteigert werden kann, wenn die Betriebsfrequenz des Tankkreises vergrößert wird. Zu höheren Frequenzen hin (f > 500 Mhz) bereitet jedoch die Realisierung von Tankkreisen aus diskreten Bauelementen, wie Spule und Kondensator, Schwierigkeiten, und auch die Kopplung zwischen Tankkreis und dem supraleitenden Ring sinkt wegen der mit zunehmender Frequenz geringer werdenden Induktivität der Tankkreisspule auf zu geringe Werte ab.

Es ist Aufgabe der Erfindung, einen Sensor zu schaffen, der mit höherer Frequenz als die bisher bekannten Sensoren dieser Art bei zumindest gleich guter Kopplung zwischen Tankkreis und dem das Josephsonelement enthaltenden, supraleitenden Ring betrieben werden kann.

Diese Aufgabe wird gemäß der Erfindung durch einen Sensor mit den Merkmalen des Anspruchs 1 gelöst.

Beim erfindungsgemäßen Sensor sind supraleitender Ring und Tankkreis ein Bauteil. Dieses besteht aus dem Streifenresonator, wobei der Streifenresonator selbst den Tankkreis und die Begrenzung der Öffnung den supraleitenden Ring, in den das Josephsonelement inkorporiert ist, bildet. Der supraleitende Ring bildet sich somit quasi erst während des Betriebs des Sensors aus.

Dadurch, daß das Josephsonelement längs einer Längsachse des Streifenresonators liegend angeordnet ist, fließt in ihm - falls ein genügend hoher Hochfrequenzstrom eingespeist wird - der für die Messung der Magnetflüsse notwendige Strom.

Für den Betrieb des Sensors ist die Resonanzfrequenz einzuspeisen, die im Streifenresonator stehende Wellen bildet. Dies kann - bei zunächst beliebiger Länge des Streifenresonators - durch Aufsuchen bzw. Einstellen der Resonanzfrequenz geschehen. Soll jedoch mit einer bestimmten Frequenz gearbeitet werden, so ist der Streifenresonator so auszulegen, daß seine elektrische Länge 1 einem ungeraden Vielfachen der Halbwellenlänge der Betriebsfrequenz entspricht.

Um den supraleitenden Ring mit inkorporiertem Josephsonelement möglichst günstig im Streifenresonator zu plazieren, wird er zweckmäßigerweise an einer Stelle maximalen Stromflusses im Streifenresonator angeordnet.

Es ist ferner für eine gute Ankopplung des Streifenresonators an die zum Betrieb des Sensors erforderliche Raumtemperaturelektronik zweckmäßig, daß das für diese Ankopplung vorgesehene weitere Stück Streifenleitung in der Nähe eines im Streifenresonator sich bildenden Spannungsbauches angeordnet ist.

Die bisher beschriebene Version des erfindungsgemäßen Sensors eignet sich in gleicher Weise wie bisher bekannte Sensoren dieser Art - allerdings mit höherer Empfindlichkeit - zur Messung der Änderung eines Magnetflusses. Dabei handelt es sich in der Regel nicht um Absolutmessungen. Vielmehr stellt man mit Sensoren dieser Art nur eine Änderung des Magnetflusses fest, entweder, indem man den Sensor bewegt oder indem man das Magnetfeld verändert. Ein - im Meßbereich - homogenes Magnetfeld ist dann daran zu erkennen, daß es keine relative Änderung des Magnetflusses zu messen gestattet.

Will man dagegen einen am Ort des Sensors inhomogenen Magnetfluß feststellen und dabei den Einfluß eines überlagernden homogenen Magnetflusses, der beispielsweise von in der Nähe befindlichen Störquellen herrühren kann, ausschalten, so bietet sich vorteilhaft eine Version des erfindungsgemäßen Sensors an, bei dem längs einer Längsachse des Streifenresonators hintereinander angeordnete Öffnungen mit dazwischen befindlichem Josephsonelement vorgesehen sind, wobei der Streifenresonator im Bereich der Öffnungen Bezug auf seine Mittel- achse unsymmetrisch ausgebildet ist.

Die Unsymmetrie des Streifenresonators im Bereich der Öffnungen dient dazu, einen Hochfrequenzstrom im Josephsonelement zu erzeugen. Sie kann beispielsweise dadurch realisiert werden, daß der Streifenresonator an einer der Öffnungen eine seitliche Aussparung und damit an dieser Stelle eine Verengung aufweist. Der dadurch bedingte Stromfluß in dieser Verengung im Streifenresonator ist ein anderer als an der entsprechenden Stelle nahe der anderen Öffnung, d. h. die Stromverteilung längs der beiden Öffnungen ist unterschiedlich. Dies führt zu einem resultierenden Strom durch das Josephsonelement.

Damit ist es zugleich möglich, einen im Bereich der beiden Öffnungen inhomogenen Magnetfluß bzw. einen in diesem Meßbereich in Bezug auf die beiden Öffnungen sich unterschiedlich ändernden Magnetfluß, beispielsweise bei sich ändernden Hirnströmen, als solchen zu erkennen bzw. zu messen.

Ausgestaltungen dieser zweiten Version des Sensors gemäß der Erfindung weisen die Merkmale der Ansprüche 6 bis 9 auf.

Eine weitere Ausgestaltung des erfindungsgemäßen Sensors besteht ferner darin, daß bei einem als Mikrobrücke ausgebildeten Josephsonelement der Teil des Substrats unterhalb des Josephsonelements aus einem Material mit möglichst geringer Wärmeleitung besteht. Dadurch kann durch die im Josephsonelement durch Dissipation entstehende Wärme der kritische Strom des Josephsonelements auf günstigere Werte verkleinert werden, wenn die Periodendauer der Betriebsfrequenz des Sensors klein ist gegen die Zeit, in der die im Josephsonelement entstehende Wärme durch Wärmeleitung wegtransportiert werden kann.

In der Zeichnung werden die beiden Versionen des Sensors gemäß der Erfindung schematisch dargestellt und im folgenden näher erläutert:

Es zeigen
- Figur 1a: die Version des Sensors mit einer Öffnung;
- Figur 1b: den Sensor gemäß Figur 1 im Längsschnitt längs der Linie A/B;
- Figur 2a: die Version des Sensors mit zwei Öffnungen;
- Figur 2b: den Sensor gemäß Figur 2 im Längsschnitt längs der Linie A/B;
- Figur 3: die mechanische Halterung des Sensors mit elektrischer Kontaktierung;
- Figur 4: ein Blockschaltbild der Auswerteelektronik.

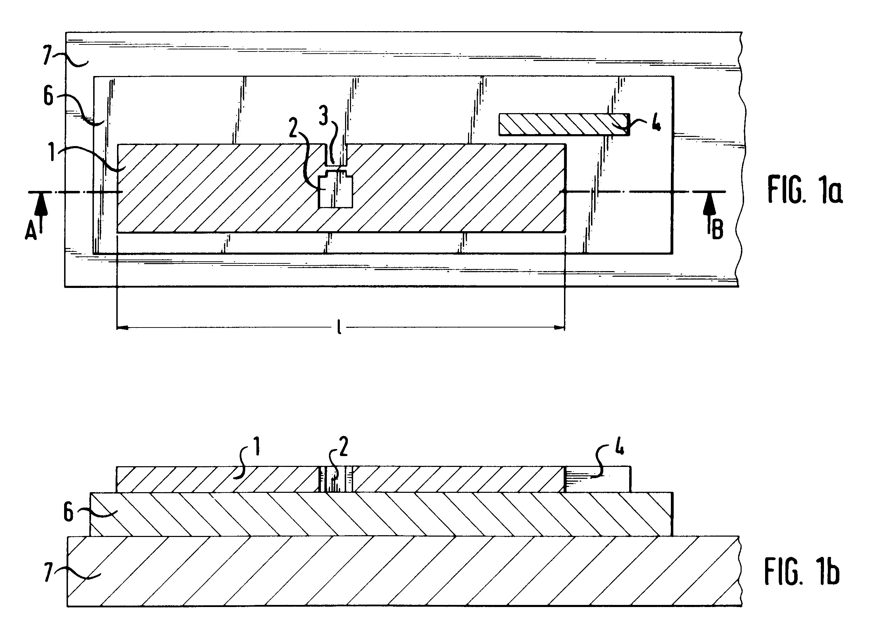

Die in Figur 1a dargestellte, einfache Version des Sensors besteht aus dem Streifenresonator 1, der darin integrierten Öffnung 2 mit dem sie umgebenden supraleitenden Ring. Dieser supraleitende Ring ist in der Zeichnung nicht wiedergegeben, da er sich erst im Betrieb als der die Öffnung umgebenden Ringstrom ausbildet. Dieser Ringstrom durchfließt das Josephsonelement 3, das längs der Mittelachse des Streifenresonators 1 angeordnet ist, wobei dafür Sorge getragen ist, daß der dem Josephsonelement gegenüberliegende Teil des Streifenresonators breiter ist als das Josephsonelement.

Der parallel zum Streifenresonator 1 angeordnete weitere Streifen 4 dient der kapazitiven Ankopplung des Streifenresonators an eine in Figur 6 dargestellte Auswerteelektronik.

Streifenresonator 1 und der weitere Streifen 4 sind auf einem Substrat 6 aufgebracht und dieses befindet sich auf dem Substrathalter 7.

Die Länge 1 des Streifenresonators ist so bemessen, daß sie einem ungeraden Vielfachen der halben Wellenlänge der Betriebsfrequenz entspricht. Das Josephsonelement ist dabei an einer Stelle maximalen Stromflusses im Streifenresonator 1 angeordnet.

Figur 1b zeigt den Sensor gemäß Figur 1 im Längsschnitt. Auf dem Substrathalter 7, der aus einem elektrisch wie thermisch gut leitenden Material (Kupfer) besteht, befindet sich das Substrat 6, das möglichst kleine dielektrische Verluste aufweist und beispielsweise aus Al₂O₃ (1 mm dick, 50Ω) besteht. In dem auf das Substrat 6 aufgebrachten Streifenresonator 1 aus supraleitendem Material (beispielsweise Nb, 100 nm dick) befindet sich die Öffnung 2.

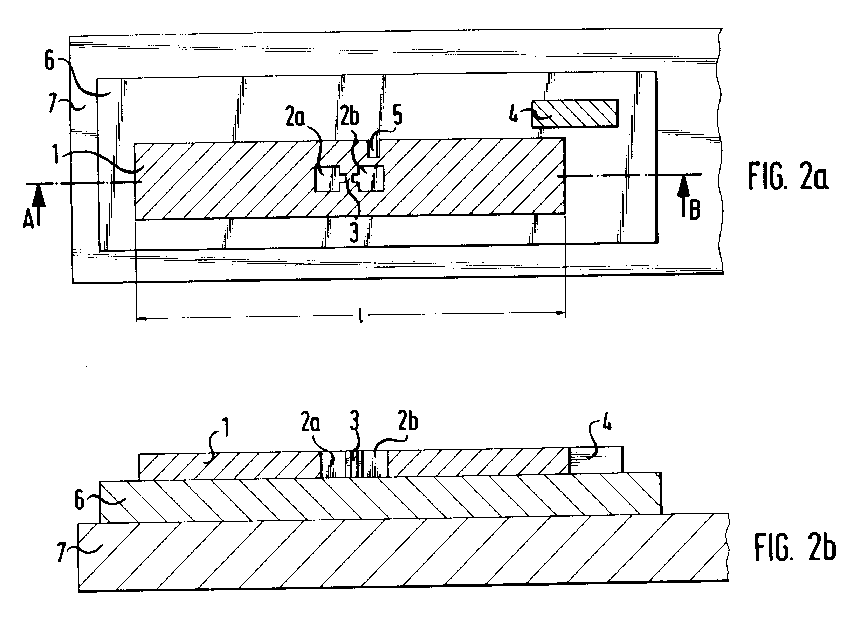

Die in Figur 2 dargestellte Sensorversion besteht aus dem Streifenresonator 1, darin integrierten zwei Öffnungen 2a und 2b mit dazwischen liegendem Josephsonelement 3 sowie dem weiteren Streifen 4.

In der Nähe der Öffnung 2b weist der Streifenresonator 1 eine Aussparung 5 auf, so daß er damit in Bezug auf seine Mittelachse unsymmetrisch ausgebildet ist. Wie weiter oben ausgeführt, ist diese Version des Sensors zur Messung inhomogener Magnetflüsse geeignet.

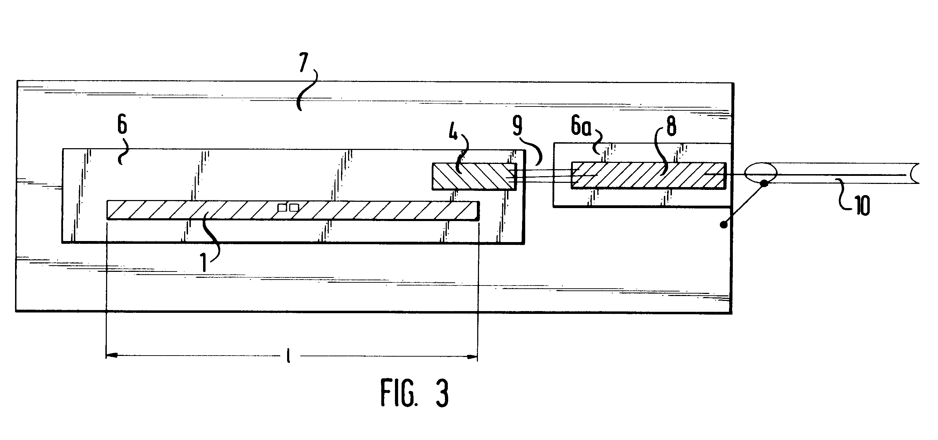

Figur 3 zeigt die mechanische Halterung des Sensors mit elektrischer Kontaktierung. Auf dem Substrathalter 7 ist über ein Substrat 6a ein weiteres Stück Streifenleitung 8 (50Ω) aufgeklebt. Das Stück Streifenleitung ist durch kurze Aluminium-Bonddrähte 9 mit der Streifenleitung 8 verbunden, an die wiederum ein Koaxialkabel 10 angelötet wird, welches zur Auswerteelektronik führt.

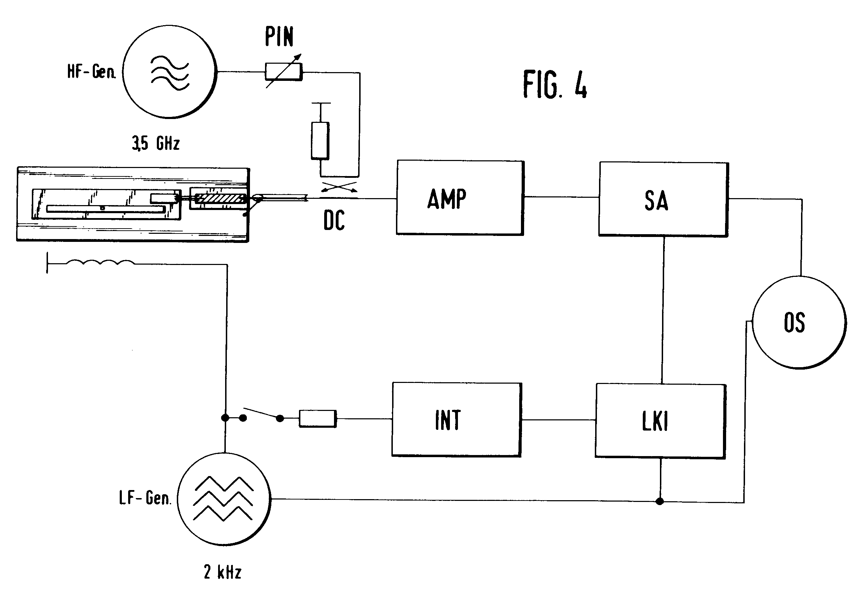

Figur 4 zeigt ein Blockschaltbild der verwendeten Auswerteelektronik, die dem bekannten Stand der Technik entspricht. Der für den Betrieb des Sensors nötige Hochfrequenzstrom (hier 3,5 G Hz) wird von einem HF Generator erzeugt. Seine Amplitude kann durch einen Abschwächer (PIN) auf einen für den jeweiligen Sensor optimalen Wert eingestellt werden. Der Strom wird über einen Richtkoppler (DC) dem Sensor eingeprägt. Die über dem Resonator abfallende Spannung wird zunächst vorverstärkt (AMP) und mittels eines Spektrumanalysators (SA) amplituden-demoduliert. Die resultierende Niederfrequenzspannung, die die Information über den den Sensor durchdringenden magnetischen Fluß enthält, kann mittels eines Oszellographen (OS) ausgewertet werden. Zum Betrieb des Sensors in einer Flußregelschleife wird mittels eines Niederfrequenzgenerators (LF-Gen) und einer nahe dem Sensor angebrachten Spule ein magnetischer Wechselfluß mit ca. 2 kHz in den Sensor eingeprägt. Über einen Lock-in-Verstärker (LKI) und Integrator (INT) kann auf diese Weise, wie bekannt, der magnetische Fluß durch den Sensor konstant gehalten werden.

Für einen Sensor nach Figur 1 wurden folgende Parameter gewählt: Das Substrat 6 bestand aus Saphir mit Abmessungen 25 x 5 x 1 mm³ (B x L x D). Durch Kathodenzerstäubung wurde ein 100 nm dicker Nb Film aufgebracht und strukturiert. Die Abmessungen dieses Streifenleiterresonators 1 betrugen 20 mm Länge und 1 mm Breite. Die Öffnung 2 des Sensors betrug 40 x 40 µm². Die als Josephsonelement 3 verwendete Mikrobrücke hatte eine Breite von 150 nm und eine Länge von 3 µm. Als Substrathalter 7 wurde ein Kupferblock gewählt. Der eingespeiste Hochfrequenzstrom hatte eine Frequenz von 3,5 GHz bei einer Leistung von -40 dBm. Die flußabhängige Spannungsänderung über dem Tankkreis betrug einige hundert µVₚₚ (µVₚₑₐₖ₋ₚₑₐₖ) an 50 Ohm.

Die Messungen wurden bei einer Temperatur des Sensors von 4,2 K durchgeführt.

## Patentansprüche

1. Sensor zum Messen von magnetischem Fluß, bestehend aus einem supraleitenden Ring mit inkorporiertem Josephsonelement (3), der an einem elektrischen Schwingkreis angekoppelt ist,
**dadurch gekennzeichnet,**
daß der elektrische Schwingkreis aus einem, einen Resonator für stehende elektrische Wellen bildenden Stück Streifenleitung (1) besteht, in der sich eine für den zu messenden Magnetfluß vorgesehene Öffnung (2) mit angrenzendem Josephsonelement (3) befindet, so daß sich der supraleitende Ring im Betrieb als der die Öffnung umgebenden Ringstrom ausbildet, wobei das Josephsonelement längs einer Längsachse des Streifenresonators liegend angeordnet ist und daß zur kapazitiven Ankopplung des Streifenresonators (1) an eine Auswerteelektronik ein am Streifenresonator anliegendes weiteres Stück Streifenleitung (4) vorgesehen ist.

2. Sensor nach Anspruch 1,
**dadurch gekennzeichnet,**
daß die elektrische Länge 1 des Streifenresonators (1) einem ungeraden Vielfachen der halben Wellenlänge der Betriebsfrequenz entspricht.

3. Sensor nach Anspruch 1 oder 2,
**dadurch gekennzeichnet,**
daß das Josephsonelement (3) an einer Stelle maximalen Stromflusses im Streifenresonator (1) angeordnet ist.

4. Sensor nach Anspruch 1 bis 3,
**dadurch gekennzeichnet,**
daß das weitere Stück Streifenleitung (4) in der Nähe eines im Streifenresonator (1) sich bildenden Spannungsbauches angeordnet ist.

5. Sensor zum Messen von magnetischem Fluß, bestehend aus einem supraleitenden Ring mit inkorporiertem Josephsonelement, der an einen elektrischen Schwingkreis angekoppelt ist,
**dadurch gekennzeichnet,**
daß der elektrische Schwingkreis aus einer, einen Resonator für stehende elektrische Wellen bildenden Stück Streifenleitung (1) besteht, in der zur Messung inhomogener Magnetflüsse zwei gleiche, längs einer Längsachse des Streifenresonators (1) hintereinander angeordnete Öffnungen (2a, 2b) mit dazwischen befindlichem Josephsonelement (3) vorgesehen sind, so daß sich der jeweilige supraleitende Ring im Betrieb als der die Öffnung umgebenden Ringstrom ausbildet, daß der Streifenresonator im Bereich der Öffnungen in Bezug auf seine Mittel- achse unsymmetrisch ausgebildet ist und daß zur kapazitiven Ankopplung des Streifenresonators (1) an eine Auswerteelektronik ein am Streifenresonator anliegendes weiteres Stück Streifenleitung (4) vorgesehen ist.

6. Sensor nach Anspruch 5,
**dadurch gekennzeichnet,**
daß die Öffnungen (2a, 2b) symmetrisch zur Mittel- achse des Streifenresonators (1) angeordnet sind

7. Sensor nach Anspruch 5 oder 6,
**dadurch gekennzeichnet,**
daß die elektrische Länge 1 des Streifenresonators (1) einem ungeraden Vielfachen der halben Wellenlänge der Betriebsfrequenz entspricht.

8. Sensor nach Anspruch 5 bis 7,
**dadurch gekennzeichnet,**
daß das Josephsonelement (3) an einer Stelle maximalen Stromflusses im Streifenresonator (1) angeordnet ist.

9. Sensor nach Anspruch 5 bis 8,
**dadurch gekennzeichnet,**
daß das weitere Stück Streifenleitung (4) in der Nähe eines im Streifenresonator (1) sich bildenden Spannungsbauches angeordnet ist.

10. Sensor nach einem der vorhergehenden Ansprüche,
**dadurch gekennzeichnet,**
daß bei einem als Mikrobrücke ausgebildeten Josephsonelement (3) der Teil des Substrats unterhalb des Josephsonelements aus einem Material mit möglichst geringer Wärmeleitung besteht.

## Claims

1. A sensor for the measurement of magnetic flux, consisting of a superconducting ring with an incorporated Josephson element (3) which is coupled to an electrical resonant circuit,
characterised in that the electrical resonant circuit consists of a piece of stripline (1) forming a resonator for standing electrical waves and in which an opening (2) with an adjacent Josephson element (3) is situated, which opening is provided for the magnetic flux to be measured, so that in operation the superconducting ring is formed as the ring current surrounding the opening, wherein the Josephson element is disposed in a horizontal position along a longitudinal axis of the strip resonator, and that a further piece of stripline (4) adjacent to the strip resonator is provided for the capacitive coupling of the strip resonator (1) to an electronic processing unit.

2. A sensor according to claim 1, characterised in that the electrical length I of the strip resonator (1) corresponds to an odd multiple of the half wavelength of the operating frequency.

3. A sensor according to claim 1 or 2, characterised in that the Josephson element (3) is disposed at a position of maximum current conduction in the strip resonator (1).

4. A sensor according to claims 1 to 3, characterised in that the further piece of stripline (4) is disposed in the vicinity of a potential loop formed in the strip resonator (1).

5. A sensor for the measurement of magnetic flux, consisting of a superconducting ring with an incorporated Josephson element which is coupled to an electrical resonant circuit,
characterised in that the electrical resonant circuit consists of a piece of stripline (1) forming a resonator for standing electrical waves and in which two identical openings (2a, 2b) disposed in series along a longitudinal axis of the strip resonator (1) and with a Josephson element (3) situated therebetween are provided for measuring inhomogeneous magnetic fluxes, so that in operation the respective superconducting ring is formed as the ring current surrounding the opening, that the strip resonator is of unsymmetrical construction with respect to its centre line in the region of the openings, and that a further piece of stripline (4) adjacent to the strip resonator is provided for the capacitive coupling of the strip resonator (1) to an electronic processing unit.

6. A sensor according to claim 5, characterised in that the openings (2a, 2b) are disposed symmetrically with respect to the centre line of the strip resonator (1).

7. A sensor according to claim 5 or 6, characterised in that the electrical length 1 of the strip resonator (1) corresponds to an odd multiple of the half wavelength of the operating frequency.

8. A sensor according to claims 5 to 7, characterised in that the Josephson element (3) is disposed at a position of maximum current conduction in the strip resonator (1).

9. A sensor according to claims 5 to 8, characterised in that the further piece of stripline (4) is disposed in the vicinity of a potential loop formed in the strip resonator (1).

10. A sensor according to any one of the preceding claims, characterised in that for a Josephson element (3) constructed as a microbridge the part of the substrate underneath the Josephson element consists of a material with a thermal conductivity as low as possible.

## Revendications

1. Capteur pour la mesure d'un flux magnétique, constitué par un anneau supraconducteur comportant un élément de Josephson incorporé (3), qui est couplé à un circuit oscillant électrique,
caractérisé en ce que le circuit oscillant électrique est constitué par un élément de conducteur en forme de bande (1), qui constitue un résonateur pour des ondes électriques stationnaires et dans lequel est située une ouverture (2) prévue pour le flux magnétique à mesurer et à laquelle est contigu l'élément de Josephson (3), de sorte que l'anneau supraconducteur se développe, en fonctionnement, sous la forme du courant annulaire qui entoure l'ouverture, l'élément de Josephson étant disposé le long d'un axe longitudinal du résonateur en forme de bande, et que pour le couplage capacitif du résonateur en forme de bande (1) à un système électronique d'évaluation, il est prévu un autre élément de conducteur en forme de bande (4), qui s'applique contre le résonateur en forme de bande.

2. Capteur suivant la revendication 1, caractérisé en ce que la longueur électrique 1 du résonateur à cavité (1) correspond à un multiple impair de la demi-longueur d'onde de la fréquence de fonctionnement.

3. Capteur suivant la revendication 1 ou 2, caractérisé en ce que l'élément de Josephson (3) est disposé en un emplacement où le flux de courant est maximum dans le résonateur en forme de bande (1).

4. Capteur suivant les revendications 1 à 3, caractérisé en ce que l'autre élément de conducteur en forme de bande (4) est disposé à proximité d'un ventre de tension qui se forme dans le résonateur en forme de bande (1).

5. Capteur pour mesurer un flux magnétique, constitué par un anneau supraconducteur avec un élément de Josephson incorporé, qui est couplé à un circuit oscillant électrique, caractérisé en ce que le circuit oscillant électrique est constitué par un élément de conducteur en forme de bande (1) qui forme un résonateur pour des ondes électriques stationnaires et dans lequel pour la mesure de flux magnétiques hétérogènes, il est prévu deux ouvertures identiques (2a,2b), qui sont disposées l'une derrière l'autre le long d'un axe longitudinal du résonateur en forme de bande (1) et entre lesquelles est situé un élément de Josephson (3), de sorte que l'anneau supraconducteur respectif se développe, en fonctionnement, sous la forme du courant annulaire entourant l'ouverture, que le résonateur en forme de bande est agencé d'une manière dissymétrique par rapport à son axe central, au voisinage des ouvertures et que pour le couplage capacitif du résonateur en forme de bande (1) à un système électronique d'évaluation, il est prévu un autre élément de conducteur en forme de bande (4), appliqué au résonateur en forme de bande.

6. Capteur suivant la revendication 5, caractérisé en ce que les ouvertures (2a,2b) sont disposées symétriquement par rapport à l'axe médian du résonateur en forme de bande (1).

7. Capteur suivant la revendication 5 ou 6, caractérisé en ce que la longueur électrique 1 du résonateur en forme de bande (1) correspond à un multiple impair de la demi-longueur d'onde de la fréquence de fonctionnement.

8. Capteur suivant les revendications 5 à 7, caractérisé en ce que l'élément de Josephson (3) est disposé en un emplacement où le flux de courant est maximum dans le résonateur en forme de bande (1).

9. Capteur suivant les revendications 5 à 8, caractérisé en ce que l'autre élément de conducteur en forme de bande (4) est disposé à proximité d'un ventre de tension qui se forme dans le résonateur en forme de bande (1).

10. Capteur suivant l'une des revendications précédentes, caractérisé en ce que dans le cas d'un élément de Josephson (3) réalisé en forme de micro-pont, la partie du substrat situé au-dessous de l'élément de Josephson est réalisée en un matériau possédant une conductibilité thermique aussi faible que possible.
